# EUROPEAN PATENT SPECIFICATION

(11) **EP 4 434 994 B1**
(45) Date of publication and mention of the grant of the patent: **03.06.2026**
(21) Application number: 22895461.6
(22) Date of filing: 07.11.2022
(51) Int. Cl.: C23C 16/18, C23C 16/40, C23C 16/455, C07F 15/00, H10P 14/42

(54) **RUTHENIUM COMPOUND, THIN FILM-FORMING MATERIAL AND METHOD FOR PRODUCING THIN FILM**
RUTHENIUMVERBINDUNG, DÜNNFILMBILDENDES MATERIAL UND VERFAHREN ZUR HERSTELLUNG EINES DÜNNFILMS
COMPOSÉ DE RUTHÉNIUM, MATÉRIAU DE FORMATION DE FILM MINCE ET PROCÉDÉ DE PRODUCTION DE FILM MINCE

(30) Priority: 18.11.2021 JP 2021188006
(43) Date of publication of application: 25.09.2024
(73) Proprietor: ADEKA CORPORATION, Arakawa-ku Tokyo 116-8554 (JP)
(72) Inventor: FUKUSHIMA, Ryota, Tokyo 116-8554 (JP); ENZU, Masaki, Tokyo 116-8554 (JP); MITSUI, Chiaki, Tokyo 116-8554 (JP); OKADA, Nana, Tokyo 116-8554 (JP); HATASE, Masako, Tokyo 116-8554 (JP)
(74) Representative: Müller-Boré & Partner Patentanwälte PartG mbB
(86) International application number: PCT/JP2022/041315
(87) International publication number: WO 2023/090179

(56) References cited:
- JP-A- 2021 520 448
- US-A1- 2015 050 431
- MUELLER J ET AL: "(ETA6-AREN)(ETA4-BUTA-1,3-DIEN)RUTHENIUM(0)-KOMPLEXE: SYNTHESE UND EIGENSCHAFTEN SOWIE KRISTALLSTURKTUR VON (BENZOL)(BUTADIEN) RUTHENIUM", JOURNAL OF ORGANOMETALLIC CHEMISTRY, ELSEVIER, AMSTERDAM, NL, vol. 458, no. 1/02, 1 January 1993 (1993-01-01), pages 219 - 224, XP000978666, ISSN: 0022-328X, DOI: 10.1016/0022-328X(93)80477-S
- ILONA JIPA ET AL: "Methylated [(benzene)(1,3-butadiene)Ru0] Derivatives as Novel MOCVD Precursors with Favorable Properties", CHEMICAL VAPOR DEPOSITION., vol. 17, no. 1-3, 1 March 2011 (2011-03-01), DE, pages 15 - 21, XP055705061, ISSN: 0948-1907, DOI: 10.1002/cvde.201006853
- YEO SEUNGMIN, PARK JI-YOON, LEE SEUNG-JOON, LEE DO-JOONG, SEO JONG HYUN, KIM SOO-HYUN: "Ruthenium and ruthenium dioxide thin films deposited by atomic layer deposition using a novel zero-valent metalorganic precursor, (ethylbenzene)(1,3-butadiene)Ru(0), and molecular oxygen", MICROELECTRONIC ENGINEERING, ELSEVIER PUBLISHERS BV., AMSTERDAM., NL, vol. 137, 1 April 2015 (2015-04-01), NL , pages 16 - 22, XP055836898, ISSN: 0167-9317, DOI: 10.1016/j.mee.2015.02.026
- ILONA JIPA, M. ASLAM SIDDIQI, REHAN A. SIDDIQUI, BURAK ATAKAN, HUBERTUS MARBACH, TILL CREMER, FLORIAN MAIER, HANS-PETER STEINR&#25: "Methylated [(benzene)(1,3-butadiene)Ru0] Derivatives as Novel MOCVD Precursors with Favorable Properties", CHEMICAL VAPOR DEPOSITION., WILEY-VCH VERLAG, WEINHEIM., DE, vol. 17, no. 1-3, 1 March 2011 (2011-03-01), DE , pages 15 - 21, XP055705061, ISSN: 0948-1907, DOI: 10.1002/cvde.201006853

## Description

### Technical Field

The present invention relates to a ruthenium compound, a thin-film forming raw material, comprising the specific ruthenium compound, and a method of producing a thin-film including producing a thin-film through use of the thin-film forming raw material.

### Background Art

Ruthenium is a metal that has low resistance and is thermally and chemically stable. A thin-film containing a ruthenium atom (hereinafter sometimes referred to as "ruthenium-containing thin-film") shows specific electrical characteristics, and is hence utilized for various applications. For example, its utilization for an electrode material of a memory device typified by a DRAM device, a wiring material, a resistance film, a diamagnetic film used for a recording layer of a hard disk, a catalyst material for a polymer electrolyte fuel cell, and a metal gate material of, for example, a MOS-FET has been known.

As a method of producing the ruthenium-containing thin-film, there are given, for example, a sputtering method, an ion plating method, a MOD method, such as a coating thermal decomposition method or a sol-gel method, and chemical vapor deposition methods. Of those, chemical vapor deposition methods including a chemical vapor deposition (CVD) method and an atomic layer deposition (ALD) method are optimum production processes because the methods have many advantages, such as excellent composition controllability and step coverage, suitability for mass production, and capability of hybrid integration.

Various raw materials that can be used in the chemical vapor deposition methods, such as the CVD method and the ALD method, have been reported. However, in a thin-film forming raw material applicable to the ALD method, it is required that a temperature region called an ALD window be sufficiently wide. It is common general technical knowledge in the art that even a thin-film forming raw material, which can be used in the CVD method, is not suitable for the ALD method in many cases.

Various compounds have been known as thin-film forming raw materials for forming the ruthenium-containing thin-film. For example, in Patent Document 1, there is a disclosure of a ruthenium complex coordinated with cyclohexadiene. In Patent Document 2, there is a disclosure of a ruthenium compound formed of two six-membered rings each having two carbonyl groups, a ruthenium atom, and a ketoimine group in a ring structure thereof. In Patent Document 3, there is a disclosure of a ruthenium-containing thin-film produced by a thermal CVD method through use of a ruthenium complex mixture and a reducing gas. In Non-Patent Document 1, there is a disclosure of a ruthenium complex in which a ketoimine group having two carbonyl groups and two five-membered ring structures is bonded to ruthenium. In Non-Patent Document 2, there is a disclosure of the synthesis, properties, and crystal structure of (η6-aren)(η4-buta-1,3-dien) ruthenium (O)-complexes. In Non-Patent Document 3, there is a disclosure of methylated [(benzene)(1,3 - butadiene)Ru⁰]-derivatives as novel MOCVD precursors with favorable properties.

### Citation List

### Patent Document

Patent Document 1: WO 2008/078296 A1
Patent Document 2: WO 2015/093177 A1
Patent Document 3: JP 2014-118605 A

### Non-Patent Document

Non-Patent Document 1: Chemistry of Materials (2003), 15(12), 2454-2462, "Synthesis and Characterization of Ruthenium Complexes with Two Fluorinated Amino Alkoxide Chelates. The Quest To Design Suitable MOCVD Source Reagents"
Non-Patent Document 2: J. Organomet. Chem. (1993), 458(1/02), 219-224, "(η6-Aren)(η4-buta-1, 3-dien) ruthenium (O)-komplexe: Synthese und Eigenschaften sowie Kristallstruktur von (Benzol)(butadien)ruthenium"
Non-Patent Document 3: Chem. Vapor Depos. (2011), 17(1-3), 15-21, "Methylated [(benzene)(1,3-butadiene)Ru0] Derivatives as Novel MOCVD Precursors with Favorable Properties"

### Summary of Invention

### Technical Problem

However, when a thin-film is produced by the ALD method through use of the ruthenium complex or the ruthenium compound described in each of Patent Documents 1 to 3, there has been a problem in that it is difficult to obtain a high-quality ruthenium-containing thin-film having a small residual carbon amount. In addition, in Non-Patent Document 1, there is no specific description that the ruthenium complex described in Non-Patent Document 1 has an ALD window or the ruthenium complex is used in the ALD method.

Accordingly, an object of the present invention is to provide a thin-film forming raw material, which is used in an atomic layer deposition method, capable of producing a high-quality ruthenium-containing thin-film having a small residual carbon amount by an ALD method, and a method of producing a thin-film using the same.

### Solution to Problem

The inventors of the present invention have made extensive investigations, and as a result, have found that the use of a thin-film forming raw material, which is used in an atomic layer deposition method, including a ruthenium compound having a specific structure, can solve the above-mentioned problems. Thus, the inventors have completed the present invention.

That is, the present invention is set out in the appended set of claims

### Advantageous Effects of Invention

According to the present invention, the thin-film forming raw material, which is used in an atomic layer deposition method, capable of forming a high-quality ruthenium-containing thin-film having a small residual carbon amount, and the method of producing a thin-film using the same can be provided.

### Brief Description of Drawings

FIG. 1 is a schematic diagram for illustrating an example of an ALD apparatus to be used in a method of producing a thin-film of the present invention.
FIG. 2 is a schematic diagram for illustrating another example of the ALD apparatus to be used in the method of producing a thin-film of the present invention.
FIG. 3 is a schematic diagram for illustrating still another example of the ALD apparatus to be used in the method of producing a thin-film of the present invention.
FIG. 4 is a schematic diagram for illustrating yet still another example of the ALD apparatus to be used in the method of producing a thin-film of the present invention.

### Description of Embodiments

### [Thin-film Forming Raw Material, which is used in Atomic Layer Deposition Method]

A thin-film forming raw material not in accordance with the claimed invention, which may be used in an atomic layer deposition method, is characterized by including a ruthenium compound represented by the general formula (1).

In the general formula (1), R¹ represents a hydrogen atom or a methyl group, and R² and R³ each independently represent a hydrogen atom or an alkyl group having 1 to 5 carbon atoms.

Examples of the alkyl group having 1 to 5 carbon atoms represented by each of R² and R³ include a methyl group, an ethyl group, a n-propyl group, an isopropyl group, a n-butyl group, an isobutyl group, a sec-butyl group, a tert-butyl group, a n-pentyl group, an isopentyl group, and a neopentyl group.

From the viewpoint that a high-quality ruthenium-containing thin-film that is flat and smooth and has a small residual carbon amount is easily produced with high productivity, R¹ preferably represents a methyl group. From the viewpoint that the ruthenium compound has a high vapor pressure, and thus a high-quality ruthenium-containing thin-film that is flat and smooth and has a small residual carbon amount is easily produced with high productivity, R² represents preferably a hydrogen atom or an alkyl group having 1 to 3 carbon atoms, more preferably a hydrogen atom or a methyl group, still more preferably a hydrogen atom. From the viewpoint that the ruthenium compound has a high vapor pressure, and thus a high-quality ruthenium-containing thin-film that is flat and smooth and has a small residual carbon amount is easily produced with high productivity, R³ represents preferably a hydrogen atom or an alkyl group having 1 to 3 carbon atoms, more preferably a hydrogen atom or a methyl group, still more preferably a methyl group.

Preferred specific examples of the ruthenium compound represented by the general formula (1) to be used in the thin-film forming raw material, which is used in an atomic layer deposition method, of the present disclosure include Compounds No. 1 to No. 12 below, wherein Ruthenium Compounds No. 7 to No. 9 fall within the present invention. In the following compounds, the symbol "Me" represents a methyl group and the symbol "Et" represents an ethyl group.

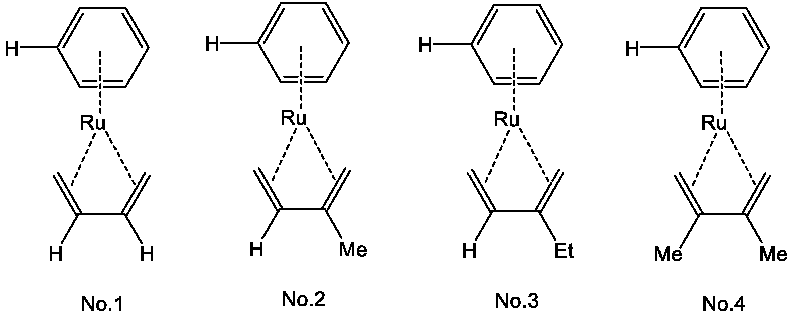

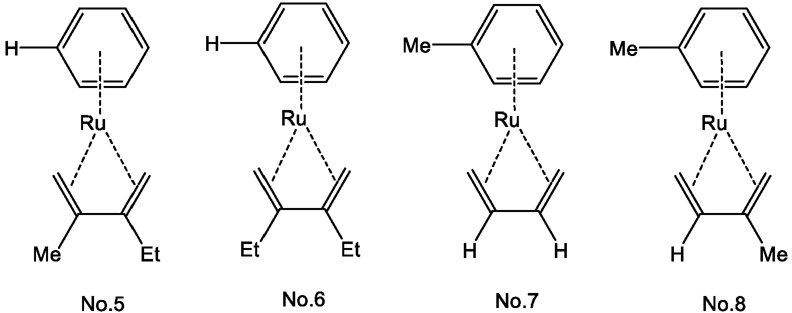

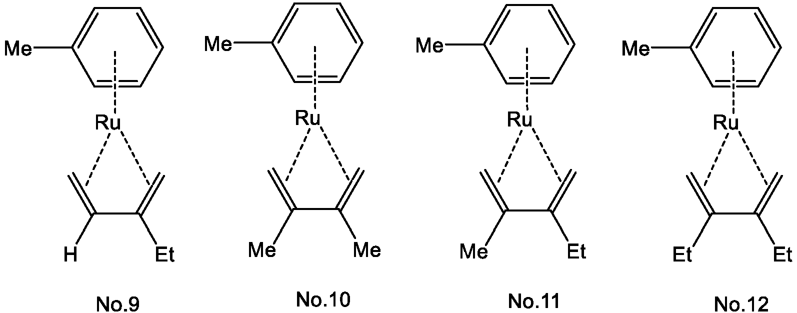

The ruthenium compound represented by the general formula (1) used in the thin-film forming raw material, which is used in an atomic layer deposition method, of the present disclosure is not particularly limited by a production method therefor, and may be produced by a well-known synthesis method. For example, the ruthenium compound may be obtained by mixing RuCl₂(benzene) or RuCl₂(toluene), sodium carbonate, and any appropriate alcohol in the presence or absence of a solvent, stirring the contents, and causing a reaction, followed by further mixing any appropriate diene compound therein, stirring the contents, and causing a reaction.

The thin-film forming raw material, which is used in an atomic layer deposition method, of the present disclosure only needs to include the ruthenium compound represented by the general formula (1) as a precursor of a thin-film, and the composition thereof varies depending on the kind of the target thin-film. For example, when a thin-film containing only a ruthenium atom as a metal is produced, the thin-film forming raw material, which is used in an atomic layer deposition method, is free of a metal compound other than ruthenium and a semimetal compound. Meanwhile, when a thin-film containing a ruthenium atom and a metal other than the ruthenium atom and/or a semimetal is produced, the thin-film forming raw material, which is used in an atomic layer deposition method, may include, in addition to the ruthenium compound represented by the general formula (1), a compound containing a desired metal and/or a compound containing a semimetal (hereinafter sometimes referred to as "other precursor").

In the case of a multi-component ALD method in which a plurality of precursors are used, there is no particular limitation on the other precursor that may be used together with the ruthenium compound represented by the general formula (1), and a well-known general precursor used for the thin-film forming raw material for an ALD method may be used.

Examples of the other precursor include compounds of: one kind or two or more kinds selected from the group consisting of compounds used as organic ligands, such as an alcohol compound, a glycol compound, a β-diketone compound, a cyclopentadiene compound, and an organic amine compound; and silicon or a metal. **In** addition, examples of the kind of the metal in the precursor include lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the other precursor include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the other precursor include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene.

Examples of the organic amine compound to be used as the organic ligand of the other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The other precursors are known in the art, and production methods therefor are also known. As an example of the production method, for example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal. Examples of the alkali metal alkoxide may include a sodium alkoxide, a lithium alkoxide, and a potassium alkoxide.

In such a multi-component ALD method as described above, there are given a method including vaporizing and supplying the thin-film forming raw material, which is used in an atomic layer deposition method, independently for each component (hereinafter sometimes referred to as "single source method"), and a method including vaporizing and supplying a mixed raw material obtained by mixing a multi-component raw material with desired composition in advance (hereinafter sometimes referred to as "cocktail source method"). In the case of the single source method, the other precursor is preferably a compound that is similar to the ruthenium compound represented by the general formula (1) in the behavior of thermal decomposition and/or oxidative decomposition. In the case of the cocktail source method, the other precursor is preferably a compound that is similar to the ruthenium compound represented by the general formula (1) in the behavior of thermal decomposition and/or oxidative decomposition, and in addition, causes no change through a chemical reaction or the like at the time of mixing.

**In** the case of the cocktail source method out of the multi-component ALD methods, a mixture of the ruthenium compound represented by the general formula (1) and the other precursor or a mixed solution obtained by dissolving the mixture in an organic solvent may be used as the thin-film forming raw material, which is used in an atomic layer deposition method.

There is no particular limitation on the organic solvent, and a well-known general organic solvent may be used. Examples of the organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof depending on the solubility of a solute, a relationship among a use temperature, a boiling point, and a flash point, and the like.

When the thin-film forming raw material, which is used in an atomic layer deposition method, of the present disclosure is the mixed solution including the organic solvent, the amount of the entire precursors in the thin-film forming raw material, which is used in an atomic layer deposition method, only needs to be controlled to from 0.01 mol/liter to 2.0 mol/liter, particularly from 0.05 mol/liter to 1.0 mol/liter. This is because a high-quality ruthenium-containing thin-film having a small residual carbon amount is easily formed.

Herein, when the thin-film forming raw material, which is used in an atomic layer deposition method, is free of any precursor other than the ruthenium compound represented by the general formula (1), the amount of the entire precursors refers to the amount of the ruthenium compound represented by the general formula (1). When the thin-film forming raw material, which is used in an atomic layer deposition method, includes any other precursor in addition to the ruthenium compound represented by the general formula (1), the amount of the entire precursors refers to the total amount of the ruthenium compound represented by the general formula (1) and the other precursor.

The thin-film forming raw material, which is used in an atomic layer deposition method, of the present disclosure may include a nucleophilic reagent as required in order to improve the stability of each of the ruthenium compound represented by the general formula (1) and the other precursor. Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane. From the viewpoint that the stability is easily controlled, the usage amount of each of those nucleophilic reagents falls within the range of preferably from 0.1 mol to 10 mol, more preferably from 1 mol to 4 mol with respect to 1 mol of the amount of the entire precursors.

It is desired that the thin-film forming raw material, which is used in an atomic layer deposition method, of the present disclosure be prevented from including impurity metal elements other than the components for forming the raw material, impurity halogens such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, a barrier layer, or a wiring layer of an LSI, it is required to reduce the contents of alkali metal elements and alkaline-earth metal elements that influence the electrical characteristics of a thin-film to be obtained. The content of the impurity halogens is preferably 100 ppm or less, more preferably 10 ppm or less, still more preferably 1 ppm or less. The total content of the impurity organic substances is preferably 500 ppm or less, more preferably 50 ppm or less, still more preferably 10 ppm or less. In addition, moisture causes generation of particles in the thin-film forming raw material, which is used in an atomic layer deposition method, and generation of particles during thin-film formation, and hence it is better to remove moisture from the precursor, the organic solvent, and the nucleophilic reagent as much as possible in advance at the time of use in order to reduce moisture in each of the precursor, the organic solvent, and the nucleophilic reagent. The moisture content of each of the precursor, the organic solvent, and the nucleophilic reagent is preferably 10 ppm or less, more preferably 1 ppm or less. This is because of the following reason: when the contents of the impurity metal elements, the impurity halogens, and the impurity organic substances, and the moisture content in the thin-film forming raw material, which is used in an atomic layer deposition method, of the present disclosure are equal to or lower than the above-mentioned numerical values, a high-quality ruthenium-containing thin-film having a small residual carbon amount is easily formed.

In addition, it is preferred that the thin-film forming raw material, which is used in an atomic layer deposition method, of the present disclosure be prevented from including particles to the extent possible in order to reduce or prevent particle contamination of a ruthenium-containing thin-film to be formed. Specifically, in particle measurement with a light scattering liquid particle detector in a liquid phase, it is preferred that the number of particles larger than 0.3 µm be 100 or less in 1 ml of the thin-film forming raw material, which is used in an atomic layer deposition method, and it is preferred that the number of particles larger than 0.2 µm be 100 or less in 1 ml of the thin-film forming raw material, which is used in an atomic layer deposition method. This is because a uniform ruthenium-containing thin-film is easily obtained.

### [Method of producing Thin-film using Thin-film Forming Raw Material, which is used in Atomic Layer Deposition Method, including Ruthenium Compound represented by General Formula (1)]

Next, a method of producing a thin-film of the present disclosure, including forming a ruthenium-containing thin-film on the surface of a substrate through use of the above-mentioned thin-film forming raw material, which is used in an atomic layer deposition method, is described.

The method of producing a thin-film of the present disclosure is not particularly limited as long as the method includes forming the ruthenium-containing thin-film through use of the thin-film forming raw material, which is used in an atomic layer deposition method, but for example, preferably includes:
a raw material introduction step of introducing a raw material gas obtained by vaporizing the thin-film forming raw material, which is used in an atomic layer deposition method, into a film formation chamber having the substrate set therein; and
a thin-film formation step of subjecting the ruthenium compound represented by the general formula (1) in the raw material gas to decomposition and/or a chemical reaction, to thereby form the ruthenium-containing thin-film on the surface of the substrate.

In particular, the method of producing a thin-film of the present disclosure more preferably further includes, between the raw material introduction step and the thin-film formation step, a precursor thin-film formation step of forming a precursor thin-film on the surface of the substrate through use of the thin-film forming raw material, which is used in an atomic layer deposition method,
wherein the thin-film formation step is a step of causing the precursor thin-film to react with a reactive gas, to thereby form the ruthenium-containing thin-film on the surface of the substrate. This is because a high-quality ruthenium-containing thin-film having a small residual carbon amount is easily obtained.

There are no particular limitations on a transportation and supply method for the raw material, a deposition method therefor, production conditions, a production apparatus, and the like, and well-known general conditions and methods may be used.

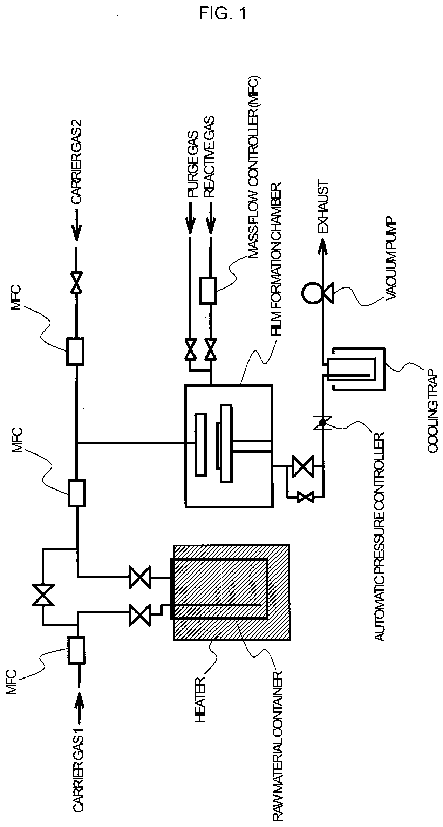

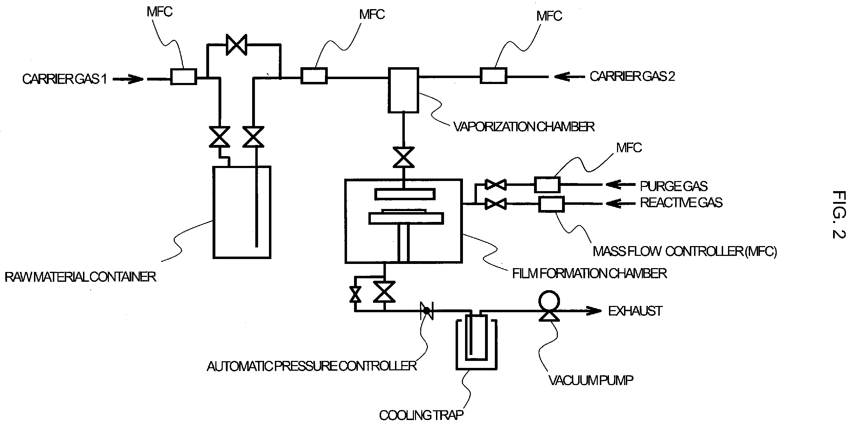

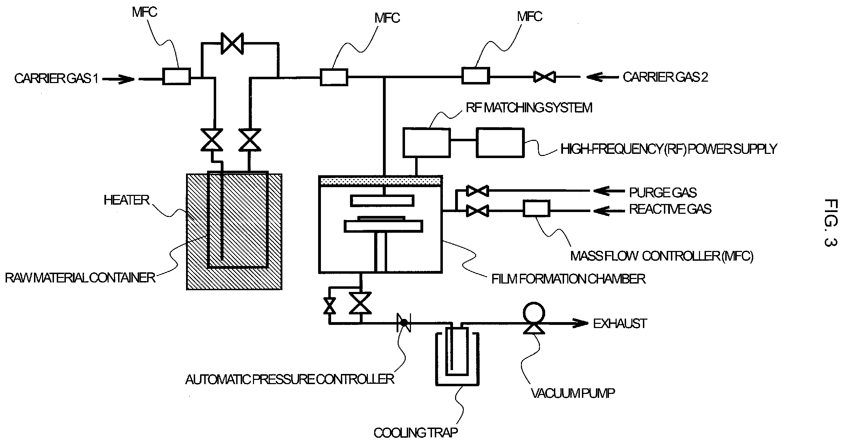

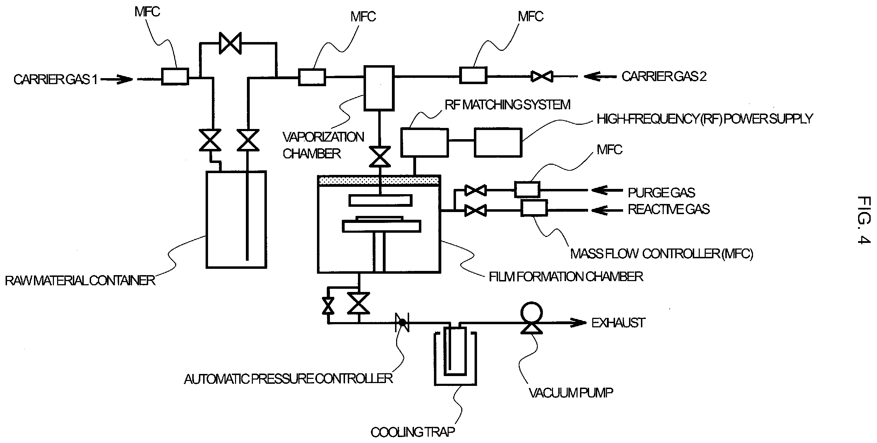

A well-known ALD apparatus may be used as an apparatus for producing a thin-film through use of the thin-film forming raw material, which is used in an atomic layer deposition method, of the present disclosure. Specific examples of the apparatus include: such an apparatus capable of performing bubbling supply of a precursor as illustrated in each of FIG. 1 and FIG. 3; and such an apparatus including a vaporization chamber as illustrated in each of FIG. 2 and FIG. 4. Another specific example thereof is such an apparatus capable of subjecting the reactive gas to plasma treatment as illustrated in each of FIG. 3 and FIG. 4. The apparatus is not limited to such single-substrate type apparatus each including a film formation chamber (hereinafter sometimes referred to as "deposition reaction portion") as illustrated in FIG. 1 to FIG. 4, and an apparatus capable of simultaneously processing a large number of substrates through use of a batch furnace may also be used. Those apparatus may also be used as CVD apparatus.

Now, the steps of such method of producing a thin-film are described.

The raw material introduction step in the present disclosure is a step of introducing a raw material gas obtained by vaporizing the thin-film forming raw material, which is used in an atomic layer deposition method, into a film formation chamber having the substrate set therein.

As a method of introducing the raw material gas obtained by vaporizing the thin-film forming raw material, which is used in an atomic layer deposition method, into the film formation chamber having the substrate set therein, there are given, for example, a gas transportation method, a liquid transportation method, a single source method, and a cocktail source method.

An example of the gas transportation method is such a method as illustrated in each of FIG. 1 and FIG. 3 including heating and/or vaporizing the thin-film forming raw material, which is used in an atomic layer deposition method, of the present disclosure in a raw material container having stored therein the thin-film forming raw material, which is used in an atomic layer deposition method, of the present disclosure, to thereby provide the raw material gas, and introducing the raw material gas into the film formation chamber having the substrate set therein together with a carrier gas, such as argon, nitrogen, or helium, as required.

An example of the liquid transportation method is such a method as illustrated in each of FIG. 2 and FIG. 4 including transporting the thin-film forming raw material, which is used in an atomic layer deposition method, to a vaporization chamber under a state of a liquid or a solution, heating and/or vaporizing the thin-film forming raw material in the vaporization chamber, to thereby provide the raw material gas, and introducing the raw material gas into the film formation chamber.

The single source method is a transportation and supply method for the thin-film forming raw material, which is used in an atomic layer deposition method, including multi-component precursors, and an example thereof is a method including vaporizing and supplying the precursors independently of each other.

An example of the cocktail source method is a method including vaporizing and supplying a mixed raw material obtained by mixing multi-component precursors with desired composition in advance. The thin-film forming raw material, which is used in an atomic layer deposition method, including the multi-component precursors may include a nucleophilic reagent or the like.

The step of vaporizing the thin-film forming raw material, which is used in an atomic layer deposition method, of the present disclosure to provide the raw material gas may be performed in the raw material container or in the vaporization chamber as described above. In each case, the thin-film forming raw material, which is used in an atomic layer deposition method, of the present disclosure is preferably vaporized at from 0°C to 200°C. This is because a high-quality ruthenium-containing thin-film is easily formed.

In addition, in the case of vaporizing the thin-film forming raw material, which is used in an atomic layer deposition method, in the raw material container or in the vaporization chamber to provide the raw material gas, the pressure in the raw material container and the pressure in the vaporization chamber each preferably fall within the range of from 1 Pa to 10,000 Pa. This is because the thin-film forming raw material, which is used in an atomic layer deposition method, is satisfactorily vaporized.

As a material for the substrate to be set in the film formation chamber, there are given, for example: silicon; ceramics, such as silicon nitride, titanium nitride, tantalum nitride, titanium oxide, ruthenium oxide, zirconium oxide, hafnium oxide, and lanthanum oxide; glass; and metals, such as metal cobalt and metal ruthenium. The shape of the substrate is, for example, a plate shape, a spherical shape, a fibrous shape, or a scaly shape. The surface of the substrate may be planar, or may have a three-dimensional structure such as a trench structure.

The thin-film formation step in the present disclosure is a step of subjecting the ruthenium compound represented by the general formula (1) in the raw material gas to decomposition and/or a chemical reaction, to thereby form the ruthenium-containing thin-film on the surface of the substrate.

The thin-film formation step is a step performed in the film formation chamber having the substrate set therein as illustrated in each of FIG. 1 to FIG. 4. The raw material gas and a reactive gas are introduced into the film formation chamber, and the ruthenium-containing thin-film is formed on the substrate in the film formation chamber through the action of the reactive gas or the action of the reactive gas and the action of heat.

When the precursor thin-film formation step described later is incorporated between the raw material introduction step and the thin-film formation step, the thin-film formation step is preferably a step of causing the precursor thin-film to react with the reactive gas, to thereby form the ruthenium-containing thin-film on the surface of the substrate. This is because a high-quality ruthenium-containing thin-film having a small residual carbon amount is easily obtained.

When the ruthenium compound represented by the general formula (1) and the reactive gas are caused to act on each other through heating in the thin-film formation step, the substrate or/and the film formation chamber only need to be heated. A heating temperature only needs to fall within the range of from room temperature to 500°C, and from the viewpoint that a high-quality ruthenium-containing thin-film is easily formed, preferably falls within the range of from 100°C to 450°C.

Examples of the reactive gas include oxygen, ozone, nitrogen dioxide, nitrogen monoxide, water vapor, hydrogen peroxide, formic acid, acetic acid, acetic anhydride, hydrogen, organic amine compounds, such as a monoalkylamine, a dialkylamine, a trialkylamine, and an alkylenediamine, hydrazine, and ammonia. Those reactive gases may be used alone or as a mixture thereof.

**In** the thin-film formation step, the reactive gas is preferably a gas containing at least one kind selected from the group consisting of: hydrogen; ammonia; oxygen; and ozone. This is because a high-quality ruthenium-containing thin-film having a small residual carbon amount is easily formed.

The method of producing a thin-film of the present disclosure preferably further includes, between the raw material introduction step and the thin-film formation step, the precursor thin-film formation step of forming a precursor thin-film on the surface of the substrate through use of the thin-film forming raw material, which is used in an atomic layer deposition method.

The precursor thin-film only needs to be a precursor thin-film capable of forming the ruthenium-containing thin-film in the thin-film formation step.

A formation method for such precursor thin-film includes causing the ruthenium compound represented by the general formula (1) in the raw material gas introduced into the film formation chamber having the substrate set therein to deposit (adsorb) onto the surface of the substrate, to thereby form the precursor thin-film on the surface of the substrate. In this case, heat may be applied by heating the substrate or heating an inside of the film formation chamber. The conditions under which the precursor thin-film is formed are not particularly limited, and for example, a reaction temperature (substrate temperature), a reaction pressure, and a deposition rate may be appropriately determined depending on the kind of the thin-film forming raw material, which is used in an atomic layer deposition method. The reaction temperature falls within the range of preferably from 0°C to 500°C, more preferably from 100°C to 450°C. This is because a uniform precursor thin-film is easily formed.

A rate at which the ruthenium compound represented by the general formula (1) in the raw material gas deposits may be controlled by the supply conditions (vaporization temperature and vaporization pressure) of the thin-film forming raw material, which is used in an atomic layer deposition method, the reaction temperature, and the reaction pressure. The deposition rate in the precursor thin-film formation step falls within the range of preferably from 0.005 nm/min to 100 nm/min, more preferably from 0.01 nm/min to 50 nm/min because a high deposition rate may deteriorate the characteristics of the precursor thin-film to be obtained, and a low deposition rate may cause a problem in productivity.

The method of producing a thin-film of the present disclosure preferably further includes, after the formation of the precursor thin-film in the precursor thin-film formation step or after the formation of the ruthenium-containing thin-film in the thin-film formation step, a step of evacuating the unreacted reactive gas, the raw material gas, and a by-product gas from the film formation chamber. This is because a high-quality ruthenium-containing thin-film having a small residual carbon amount is easily obtained. In this case, it is ideal that the unreacted reactive gas, the raw material gas, and the by-product gas be completely evacuated from the film formation chamber, but it is not always required that the gases be completely evacuated. As an evacuation method, there are given, for example: a method including purging a system of the film formation chamber with an inert gas, such as helium, nitrogen, or argon; a method including performing evacuation by decompressing the system of the film formation chamber; and a combination of these methods. The degree of decompression in the case of decompressing the system preferably falls within the range of from 0.01 Pa to 300 Pa, and from the viewpoint that the evacuation of the unreacted reactive gas, the raw material gas, and the by-product gas is promoted, more preferably falls within the range of from 0.01 Pa to 100 Pa.

The method of producing a thin-film of the present disclosure may further include a step of applying energy, such as plasma, light, or a voltage, or a step of using a catalyst. The timing at which the energy is applied and the timing at which the catalyst is used are not particularly limited. The energy may be applied or the catalyst may be used, for example, at the time of the introduction of the raw material gas in the raw material gas introduction step, at the time of the heating in the precursor thin-film formation step or in the thin-film formation step, at the time of the evacuation of the system in the evacuation step, or at the time of the introduction of the reactive gas in the thin-film formation step, or between the above-mentioned respective steps.

When plasma treatment is performed in the method of producing a thin-film of the present disclosure, the output thereof is preferably from 10 W to 1,500 W, more preferably from 50 W to 600 W because an excessively high output causes large damage to the substrate.

In order to achieve more satisfactory electrical characteristics of the ruthenium-containing thin-film, the method of producing a thin-film of the present disclosure may further include an annealing step after the formation of the thin-film. In the annealing step, annealing treatment may be performed under an inert atmosphere, an oxidizing atmosphere, or a reducing atmosphere, and in the case where step embedding is required, a reflow step may be provided. From the viewpoint that a high-quality ruthenium-containing thin-film having a small residual carbon amount is easily produced, a temperature in the annealing step falls within the range of preferably from 200°C to 1,000°C, more preferably from 250°C to 500°C.

The method of producing a thin-film of the present disclosure may be a method including performing the thin-film formation step only once, or may be a method including performing the thin-film formation step twice or more, but is preferably a method including performing the thin-film formation step twice or more. In the present disclosure, the formation of a ruthenium-containing thin-film having a desired film thickness only needs to be performed as follows: the raw material gas introduction step, the precursor thin-film formation step, the evacuation step, the thin-film formation step, and the evacuation step are sequentially performed, and the formation of the ruthenium-containing thin-film through the series of operations is defined as one cycle; and the cycle is repeated a plurality of times until a ruthenium-containing thin-film having a required film thickness is obtained. The film thickness of the ruthenium-containing thin-film to be formed may be controlled by the number of cycles. The deposition rate of the ruthenium-containing thin-film obtained per cycle falls within the range of preferably from 0.001 nm/min to 100 nm/min, more preferably from 0.005 nm/min to 50 nm/min. This is because a uniform ruthenium-containing thin-film is easily obtained when the deposition rate falls within the above-mentioned ranges.

### [Thin-film obtained by using Thin-film Forming Raw Material, which is used in Atomic Layer Deposition Method]

A thin-film obtained by using the thin-film forming raw material, which is used in an atomic layer deposition method, of the present disclosure is, for example, a thin-film of ruthenium metal, ruthenium oxide, or ruthenium nitride, and a thin-film of ruthenium metal can be efficiently formed by the above-mentioned method of producing a thin-film. A thin-film of the present disclosure can be obtained as a desired kind of thin-film by appropriately selecting the other precursor, the reactive gas, and the production conditions in the method of producing a thin-film described above. The thin-film of the present disclosure is excellent in electrical characteristics and optical characteristics, and hence can be widely used in the production of, for example, electrode materials of memory devices typified by DRAM devices, wiring materials of semiconductor devices, diamagnetic films used for recording layers of hard disks, and catalyst materials for polymer electrolyte fuel cells.

### [Ruthenium Compound]

A ruthenium compound of the present invention is a ruthenium compound represented by the general formula (2).
The ruthenium compound of the present invention can be preferably used as a thin-film forming raw material for chemical vapor deposition, and can be more preferably used as the thin-film forming raw material, which is used in an atomic layer deposition method, because the compound has an ALD window.

Examples of the alkyl group having 1 to 5 carbon atoms that is represented by R⁴ in the general formula (2) include a methyl group, an ethyl group, a n-propyl group, an isopropyl group, a n-butyl group, an isobutyl group, a sec-butyl group, a tert-butyl group, a n-pentyl group, an isopentyl group, and a neopentyl group.

In the general formula (2), R⁴ is appropriately selected depending on the method of producing a thin-film to be applied. For use in the method of producing a thin-film including a step of vaporizing the ruthenium compound, R⁴ is selected so as to provide a high vapor pressure and a low melting point, and thus a high-quality ruthenium-containing thin-film is easily produced with high productivity.

From the viewpoint that the ruthenium compound has a high vapor pressure, and thus a high-quality ruthenium-containing thin-film that is flat and smooth and has a small residual carbon amount is easily produced with high productivity, R⁴ represents preferably a hydrogen atom or an alkyl group having 1 to 3 carbon atoms, more preferably a hydrogen atom or a methyl group, still more preferably a methyl group.

In addition, for use in the method of producing a thin-film by a MOD method not involving a vaporization step, R⁴ may be appropriately selected depending on, for example, the solubility of the ruthenium compound in a solvent to be used, and a thin-film formation reaction.

Specific preferred examples of the ruthenium compound represented by the general formula (2) include Ruthenium Compounds No. 7 to No. 9 described above, but the present invention is not limited to these ruthenium compounds.

The ruthenium compound represented by the general formula (2) is not particularly limited by a production method therefor, and may be produced by a well-known synthesis method. Specifically, the ruthenium compound represented by the general formula (2) may be produced by the same method as the ruthenium compound represented by the general formula (1) described above.

### [Thin-film Forming Raw Material]

A thin-film forming raw material of the present invention is characterized by including the ruthenium compound represented by the general formula (2). The composition of the thin-film forming raw material of the present invention varies depending on the kind of the target thin-film. For example, when a thin-film containing only a ruthenium atom as a metal is to be produced, the thin-film forming raw material is free of a metal compound other than ruthenium and a semimetal compound. Meanwhile, when a thin-film containing a ruthenium atom and a metal other than the ruthenium atom and/or a semimetal is to be produced, the thin-film forming raw material may include, in addition to the ruthenium compound represented by the general formula (2), a compound containing a desired metal and/or a compound containing a semimetal (hereinafter sometimes referred to as "other precursor"). The ruthenium compound represented by the general formula (2) serving as a precursor has physical properties suitable for CVD methods, and hence the thin-film forming raw material of the present invention is useful as a thin-film forming raw material for CVD methods. The ruthenium compound represented by the general formula (2) has an ALD window, and hence the thin-film forming raw material of the present invention is particularly useful as the thin-film forming raw material, which is used in an atomic layer deposition method, out of the CVD methods.

In the case of a multi-component CVD method in which a plurality of precursors are used, there is no particular limitation on the other precursor that may be used together with the ruthenium compound represented by the general formula (2), and a well-known general precursor used for the thin-film forming raw material for a CVD method may be used.

The same other precursors as those given as examples in the [Thin-film Forming Raw Material, which is used in Atomic Layer Deposition Method] section may each be used as the other precursor.

In such a multi-component CVD method as described above, there are given a method including vaporizing and supplying the thin-film forming raw material independently for each component (hereinafter sometimes referred to as "single source method"), and a method including vaporizing and supplying a mixed raw material obtained by mixing a multi-component raw material with desired composition in advance (hereinafter sometimes referred to as "cocktail source method"). In the case of the single source method, the other precursor is preferably a compound that is similar to the ruthenium compound represented by the general formula (2) in the behavior of thermal decomposition and/or oxidative decomposition. In the case of the cocktail source method, the other precursor is preferably a compound that is similar to the ruthenium compound represented by the general formula (2) in the behavior of thermal decomposition and/or oxidative decomposition, and in addition, causes no change through a chemical reaction or the like at the time of mixing.

In the case of the cocktail source method out of the multi-component CVD methods, a mixture of the ruthenium compound represented by the general formula (2) and the other precursor or a mixed solution obtained by dissolving the mixture in an organic solvent may be used as the thin-film forming raw material.

The same organic solvents as those given as examples in the [Thin-film Forming Raw Material, which is used in Atomic Layer Deposition Method] section may each be used as the organic solvent.

When the thin-film forming raw material of the present invention is the mixed solution including the organic solvent, the amount of the entire precursors in the thin-film forming raw material only needs to be controlled to from 0.01 mol/liter to 2.0 mol/liter, particularly from 0.05 mol/liter to 1.0 mol/liter. This is because a high-quality ruthenium-containing thin-film having a small residual carbon amount is easily formed.

Herein, when the thin-film forming raw material is free of any precursor other than the ruthenium compound represented by the general formula (2), the amount of the entire precursors refers to the amount of the ruthenium compound represented by the general formula (2). When the thin-film forming raw material includes any other precursor in addition to the ruthenium compound represented by the general formula (2), the amount of the entire precursors refers to the total amount of the ruthenium compound represented by the general formula (2) and the other precursor.

The thin-film forming raw material of the present invention may include a nucleophilic reagent as required in order to improve the stability of each of the ruthenium compound represented by the above-mentioned general formula (2) and the other precursor. The same nucleophilic reagents as those given as examples in the [Thin-film Forming Raw Material, which is used in Atomic Layer Deposition Method] section may each be used as the nucleophilic reagent.

It is desired that the thin-film forming raw material of the present invention be prevented from including impurity metal elements other than the components for forming the raw material, impurity halogens such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, a barrier layer, or a wiring layer of an LSI, it is required to reduce the contents of alkali metal elements and alkaline-earth metal elements that influence the electrical characteristics of a ruthenium-containing thin-film to be obtained. The content of the impurity halogens is preferably 100 ppm or less, more preferably 10 ppm or less, still more preferably 1 ppm or less. The total content of the impurity organic substances is preferably 500 ppm or less, more preferably 50 ppm or less, still more preferably 10 ppm or less. In addition, moisture causes generation of particles in the thin-film forming raw material and generation of particles during thin-film formation, and hence it is better to remove moisture from the precursor, the organic solvent, and the nucleophilic reagent as much as possible in advance at the time of use in order to reduce moisture in each of the precursor, the organic solvent, and the nucleophilic reagent. The moisture content of each of the precursor, the organic solvent, and the nucleophilic reagent is preferably 10 ppm or less, more preferably 1 ppm or less. This is because of the following reason: when the contents of the impurity metal elements, the impurity halogens, and the impurity organic substances, and the moisture content in the thin-film forming raw material of the present invention are equal to or lower than the above-mentioned numerical values, a high-quality ruthenium-containing thin-film having a small residual carbon amount is easily formed.

In addition, it is preferred that the thin-film forming raw material of the present invention be prevented from including particles to the extent possible in order to reduce or prevent particle contamination of a ruthenium-containing thin-film to be formed. Specifically, in particle measurement with a light scattering liquid particle detector in a liquid phase, it is preferred that the number of particles larger than 0.3 µm be 100 or less in 1 ml of the thin-film forming raw material, and it is preferred that the number of particles larger than 0.2 µm be 100 or less in 1 ml of the thin-film forming raw material. This is because a uniform ruthenium-containing thin-film is easily obtained.

### [Method of producing Thin-film using Thin-film Forming Raw Material including Ruthenium Compound represented by General Formula (2)]

Next, a method of producing a thin-film of the present invention, including forming a ruthenium-containing thin-film on the surface of a substrate through use of the above-mentioned thin-film forming raw material, is described.

The method of producing a thin-film of the present invention is not particularly limited as long as the method includes forming the ruthenium-containing thin-film through use of the thin-film forming raw material, but for example, preferably includes:
a raw material introduction step of introducing a raw material gas obtained by vaporizing the thin-film forming raw material into a film formation chamber having the substrate set therein; and
a thin-film formation step of subjecting the ruthenium compound represented by the general formula (2) in the raw material gas to decomposition and/or a chemical reaction, to thereby form the ruthenium-containing thin-film on the surface of the substrate.

In particular, the method of producing a thin-film of the present invention more preferably further includes, between the raw material introduction step and the thin-film formation step, a precursor thin-film formation step of forming a precursor thin-film on the surface of the substrate through use of the thin-film forming raw material,
wherein the thin-film formation step is a step of causing the precursor thin-film to react with a reactive gas, to thereby form the ruthenium-containing thin-film on the surface of the substrate. This is because a high-quality ruthenium-containing thin-film having a small residual carbon amount is easily obtained.

There are no particular limitations on a transportation and supply method for the raw material, a deposition method therefor, production conditions, a production apparatus, and the like, and well-known general conditions and methods may be used.

A well-known ALD apparatus may be used as an apparatus for producing a thin-film through use of the thin-film forming raw material of the present invention. As a specific example of the apparatus, the same ALD apparatus as those given as examples in the [Method of producing Thin-film using Thin-film Forming Raw Material, which is used in Atomic Layer Deposition Method, including Ruthenium Compound represented by General Formula (1)] section may each be used. Those apparatus may also be used as CVD apparatus.

Now, the steps of such method of forming a thin-film are described.

The raw material introduction step in the present invention is a step of introducing a raw material gas obtained by vaporizing the thin-film forming raw material into a film formation chamber having the substrate set therein. As a method of introducing the thin-film forming raw material and the like, the method and the like given as examples in the [Method of producing Thin-film using Thin-film Forming Raw Material, which is used in Atomic Layer Deposition Method, including Ruthenium Compound represented by General Formula (1)] section may be adopted, and hence the description thereof is omitted here.

The thin-film formation step in the present invention is a step of subjecting the ruthenium compound represented by the general formula (2) in the raw material gas to decomposition and/or a chemical reaction, to thereby form the ruthenium-containing thin-film on the surface of the substrate. As a method of forming the thin-film and the like, the method and the like given as examples in the [Method of producing Thin-film using Thin-film Forming Raw Material, which is used in Atomic Layer Deposition Method, including Ruthenium Compound represented by General Formula (1)] section may be adopted, and hence the description thereof is omitted here.

The method of producing a thin-film of the present invention preferably further includes, between the raw material introduction step and the thin-film formation step, the precursor thin-film formation step of forming a precursor thin-film on the surface of the substrate through use of the thin-film forming raw material.

In the thin-film formation step, the precursor thin-film only needs to be a thin-film capable of forming the ruthenium-containing thin-film.

As a method of forming such precursor thin-film and the like, the method and the like given as examples in the [Method of producing Thin-film using Thin-film Forming Raw Material, which is used in Atomic Layer Deposition Method, including Ruthenium Compound represented by General Formula (1)] section may be adopted, and hence the description thereof is omitted here.

The method of producing a thin-film of the present invention preferably further includes, after the formation of the precursor thin-film in the precursor thin-film formation step or after the formation of the ruthenium-containing thin-film in the thin-film formation step, an evacuation step of evacuating the unreacted reactive gas, the raw material gas, and a by-product gas from the film formation chamber. This is because a high-quality ruthenium-containing thin-film having a small residual carbon amount is easily obtained. In this case, it is ideal that the unreacted reactive gas, the raw material gas, and the by-product gas be completely evacuated from the film formation chamber, but it is not always required that the gases be completely evacuated. The evacuation step in this case is the same as the evacuation step described in the [Method of producing Thin-film using Thin-film Forming Raw Material, which is used in Atomic Layer Deposition Method, including Ruthenium Compound represented by General Formula (1)] section, and hence the description thereof is omitted here.

The method of producing a thin-film of the present invention may further include an application step of applying energy, such as plasma, light, or a voltage, or a step of using a catalyst. The application step of applying energy or the step of using a catalyst in this case is the same as the application step of applying energy or the step of using a catalyst described in the [Method of producing Thin-film using Thin-film Forming Raw Material, which is used in Atomic Layer Deposition Method, including Ruthenium Compound represented by General Formula (1)] section, and hence the description thereof is omitted here.

In order to achieve more satisfactory electrical characteristics of the ruthenium-containing thin-film, the method of producing a thin-film of the present invention may further include an annealing step after the formation of the thin-film. The annealing step in this case is the same as the annealing step described in the [Method of producing Thin-film using Thin-film Forming Raw Material, which is used in Atomic Layer Deposition Method, including Ruthenium Compound represented by General Formula (1)] section, and hence the description thereof is omitted here.

The method of producing a thin-film of the present invention may be a method including performing the thin-film formation step only once, or may be a method including performing the thin-film formation step twice or more, but is preferably a method including performing the thin-film formation step twice or more. In the present invention, the formation of a ruthenium-containing thin-film having a desired film thickness only needs to be performed as follows: the raw material gas introduction step, the precursor thin-film formation step, the evacuation step, the thin-film formation step, and the evacuation step are sequentially performed, and the formation of the thin-film through the series of operations is defined as one cycle; and the cycle is repeated a plurality of times until a ruthenium-containing thin-film having a required film thickness is obtained. The film thickness of the ruthenium-containing thin-film to be formed may be controlled by the number of cycles. The deposition rate of the ruthenium-containing thin-film obtained per cycle falls within the range of preferably from 0.001 nm/min to 100 nm/min, more preferably from 0.005 nm/min to 50 nm/min. This is because a uniform ruthenium-containing thin-film is easily obtained when the deposition rate falls within the above-mentioned ranges.

### [Thin-film obtained by using Thin-film Forming Raw Material]

A thin-film obtained by using the thin-film forming raw material of the present invention is a thin-film of ruthenium metal, ruthenium oxide, or ruthenium nitride, and a thin-film of ruthenium metal can be efficiently formed by the above-mentioned method of producing a thin-film. The thin-film can be obtained as a desired kind of thin-film by appropriately selecting the other precursor, the reactive gas, and the production conditions in the method of producing a thin-film described above. The thin-film obtained by using the thin-film forming raw material of the present invention is excellent in electrical characteristics and optical characteristics, and hence can be widely used in the production of, for example, electrode materials of memory devices typified by DRAM devices, wiring materials of semiconductor devices, diamagnetic films used for recording layers of hard disks, and catalyst materials for polymer electrolyte fuel cells.

### Examples

Now, the present invention is described in more detail by way of Examples. However, the present invention is not limited by the following Examples and the like.

### [Example 1] Production of Ruthenium Compound No. 7

2.14 Grams of [RuCl₂(toluene)]₂, 2.57 g of sodium carbonate, and 18.0 ml of 2-propanol were added to a reaction flask to be dissolved, followed by stirring at room temperature for 2 hours. 21.4 Milliliters of a butadiene/15% hexane solution was added to the resultant solution, followed by stirring under heating reflux conditions for 6 hours. The reaction liquid was subjected to removal of the solvent in an oil bath at 90°C under reduced pressure. 50.0 Milliliters of hexane was added to the resultant residue, and the residue was subjected to filtration. The resultant filtrate was subjected to removal of the solvent in an oil bath at 65°C under reduced pressure. A ruthenium complex generated was distilled in an oil bath at 110°C under 90 Pa. Thus, Compound No. 7 was obtained as a yellow liquid (yield: 0.80 g, percent yield: 40%).

### (Analysis Values)

### (1) Normal-pressure TG-DTA

50% mass loss temperature: 200°C (760 Torr, Ar flow rate: 100 ml/min, temperature increase at 10°C/min)

### (2) Reduced-pressure TG-DTA

50% mass loss temperature: 111°C (10 Torr, Ar flow rate: 50 ml/min, temperature increase at 10°C/min)

### (3) ¹H-NMR (deuterated benzene)

0.275-0.310 ppm (2H, double doublet), 1.782 ppm (3H, singlet), 1.850-1.898 ppm (2H, double doublet), 4.716-4.760 ppm (3H, multiplet), 4.914-4.928 ppm (2H, multiplet), 4.997-5.024 ppm (2H, multiplet)

### (4) Result of Elemental Analysis by ICP-AES

Ru: 40.87 mass% (theoretical value: 40.89 mass%), C: 53.42 mass% (theoretical value: 53.41 mass%), H: 5.71 mass% (theoretical value: 5.70 mass%)

### [Example 2] Production of Ruthenium Compound No. 8

5.00 Grams of [RuCl₂(toluene)]₂, 6.01 g of sodium carbonate, and 24.0 ml of 2-propanol were added to a reaction flask to be dissolved, followed by stirring at room temperature for 2 hours. 4.73 Milliliters of isoprene was added to the resultant solution, followed by stirring under heating reflux conditions for 6 hours. The reaction liquid was subjected to removal of the solvent in an oil bath at 90°C under reduced pressure. 50.0 Milliliters of hexane was added to the resultant residue, and the residue was subjected to filtration. The resultant filtrate was subjected to removal of the solvent in an oil bath at 65°C under reduced pressure. A ruthenium complex generated was distilled in an oil bath at 110°C under 90 Pa. Thus, Compound No. 8 was obtained as a yellow liquid (yield: 1.96 g, percent yield: 40%).

### (Analysis Values)

### (1) Normal-pressure TG-DTA

50% mass loss temperature: 200°C (760 Torr, Ar flow rate: 100 ml/min, temperature increase at 10°C/min)

### (2) Reduced-pressure TG-DTA

50% mass loss temperature: 111°C (10 Torr, Ar flow rate: 50 ml/min, temperature increase at 10°C/min)

### (3) ¹H-NMR (deuterated benzene)

0.145-0.168 ppm (1H, double doublet), 0.341 ppm (1H, singlet), 1.744 ppm (3H, singlet), 1.823-1.842 ppm (1H, double doublet), 1.943 ppm (4H, singlet), 4.693-4.754 ppm (2H, multiplet), 4.798-4.826 ppm (2H, multiplet), 4.887-4.915 ppm (1H, multiplet), 5.067-5.094 ppm (1H, triplet)

### (4) Result of Elemental Analysis by ICP-AES

Ru: 38.70 mass% (theoretical value: 38.68 mass%), C: 55.14 mass% (theoretical value: 55.15 mass%), H: 6.16 mass% (theoretical value: 6.17 mass%)

### [Evaluation Example] Evaluation of Physical Properties of Compound

The following evaluations were performed on Ruthenium Compounds No. 1, No. 2, No. 4, No. 7, No. 8, and No. 10, wherein the evaluations performed on Ruthenium Compounds No. 1, No. 2, No. 4, and No. 10 are Reference Evaluation Examples, and the following Comparative Compound 1 and Comparative Compound 2. In the following chemical formulae, the symbol "Me" represents a methyl group, the symbol "Et" represents an ethyl group, and the symbol "iPr" represents an isopropyl group.

### (1) Evaluation of Melting Point

The state of each of the compounds at normal pressure and 25°C was visually observed. A compound that was a solid at 25°C was measured for a melting point with a micro melting point-measuring device. The results are shown in Table 1.

### (2) Temperature (°C) at Time of 50 Mass% Loss in Normal-pressure TG-DTA

A change in weight of each of test compounds was measured with a TG-DTA at 10 Torr, an Ar flow rate of 50 mL/min, and a temperature increase rate of 10°C/min in the scanning temperature range of from 30°C to 600°C, and a temperature (°C) when the weight of the test compound reduced by 50 mass% was evaluated as a "temperature (°C) at the time of a 50 mass% loss in normal-pressure TG-DTA." A lower temperature (°C) at the time of a 50 mass% loss in normal-pressure TG-DTA means that vapor is obtained at a lower temperature. The results are shown in Table 1.

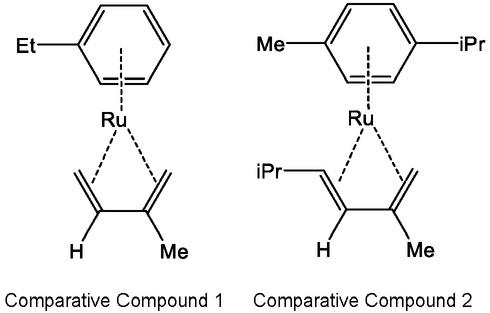

**Table 1**

| | Compound | State at 25°C | Melting point [°C] | Temperature [°C] at time of 50 mass% loss in normal-pressure TG-DTA |
|---|---|---|---|---|
| Reference Evaluation Example 1 | No. 1 | Solid | 108 | 193 |
| Reference Evaluation Example 2 | No. 2 | Solid | 71 | 195 |
| Reference Evaluation Example 3 | No. 4 | Solid | 83 | 200 |
| Evaluation Example 4 | No. 7 | Liquid | - | 200 |
| Evaluation Example 5 | No. 8 | Liquid | - | 200 |
| Reference Evaluation Example 6 | No. 10 | Solid | 48 | 203 |
| Comparative Evaluation Example 1 | Comparative Compound 1 | Liquid | - | 208 |
| Comparative Evaluation Example 2 | Comparative Compound 2 | Liquid | - | 225 |

As shown in Table 1, Comparative Compound 1 and Comparative Compound 2 each had a temperature at the time of a 50 mass% loss in normal-pressure TG-DTA of 208°C or more. Meanwhile, Ruthenium Compounds No. 1, No. 2, No. 4, No. 7, No. 8, and No. 10 each had a temperature at the time of a 50 mass% loss in normal-pressure TG-DTA of 203°C or less, and hence, were each found to be a compound having a high vapor pressure. In addition, Ruthenium Compounds No. 7, No. 8, and No. 10 each had a melting point of less than 50°C, and hence, were each found to be a compound having a low melting point. Of the Ruthenium Compounds, Ruthenium Compounds No. 7 and No. 8 were each found to be a compound having a particularly low melting point because its state at 25°C was a liquid.

### [Production of Thin-film by ALD Method]

Next, a thin-film was produced by using each of the compounds having been evaluated in the foregoing as a thin-film forming raw material, which was used in an atomic layer deposition method.

### [Example 3]

A thin-film was produced on the surface of a silicon wafer serving as a substrate by using Ruthenium Compound No. 8 as a thin-film forming raw material, which was used in an atomic layer deposition method, with the ALD apparatus of FIG. 1 under the following conditions. When the composition of the thin-film was analyzed by using X-ray photoelectron spectroscopy, it was recognized that the thin-film was a thin-film of ruthenium metal, and a residual carbon content was less than 0.1 atom%, which was a detection limit. In addition, when the film thickness of the thin-film was measured by using scanning electron microscopy, the thin-film formed on the surface of the silicon wafer was a flat and smooth film having a film thickness of 11 nm, and a film thickness of about 0.11 nm was obtained per cycle.

### (Conditions)

Production method: ALD method
Reaction temperature (substrate temperature): 230°C
Reactive gas: Oxygen

### (Steps)

A series of steps including the following steps (1) to (4) was defined as one cycle, and the cycle was repeated 100 times.
(1) Vapor of the thin-film forming raw material (raw material gas) obtained by vaporization under the conditions of a raw material container temperature of 100°C and a raw material container internal pressure of 100 Pa is introduced into a film formation chamber (raw material introduction step), and the raw material gas is caused to deposit on the surface of the substrate at a system pressure of 100 Pa for 20 seconds, to thereby form a precursor thin-film (precursor thin-film formation step).
(2) The raw material gas that has not deposited on the surface of the substrate is evacuated from the system through argon purging for 15 seconds (evacuation step).
(3) A reactive gas is introduced into the film formation chamber, and the precursor thin-film is caused to react with the reactive gas at a system pressure of 100 Pa for 20 seconds (thin-film formation step).
(4) The reactive gas that is unreacted and a by-product gas are evacuated from the system through argon purging for 15 seconds (evacuation step).

### [Example 4]

A thin-film was produced on the surface of a silicon wafer by the same method as in Example 3 except that Ruthenium Compound No. 7 was used as the thin-film forming raw material, which was used in an atomic layer deposition method, in place of Ruthenium Compound No. 8. When the composition of the thin-film was analyzed by X-ray photoelectron spectroscopy, it was recognized that the thin-film was a thin-film of ruthenium metal, and a residual carbon amount was less than 0.1 atom%, which was a detection limit. In addition, when the film thickness of the thin-film was measured by scanning electron microscopy, the thin-film formed on the surface of the silicon wafer was a flat and smooth film having a film thickness of 10 nm, and a film thickness of about 0.10 nm was obtained per cycle.

### [Reference Example 5]

A thin-film was produced on the surface of a silicon wafer by the same method as in Example 3 except that Ruthenium Compound No. 10 was used as the thin-film forming raw material, which was used in an atomic layer deposition method, in place of Ruthenium Compound No. 8, and the reactive gas was changed to hydrogen plasma (plasma output: 100 W), and the ALD apparatus was changed to the ALD apparatus of FIG. 3. When the composition of the thin-film was analyzed by X-ray photoelectron spectroscopy, it was recognized that the thin-film was a thin-film of ruthenium metal, and a residual carbon amount was less than 0.1 atom%, which was a detection limit. In addition, when the film thickness of the thin-film was measured by scanning electron microscopy, the thin-film formed on the surface of the silicon wafer was a flat and smooth film having a film thickness of 9 nm, and a film thickness of about 0.09 nm was obtained per cycle.

### [Comparative Example 1]

A thin-film was produced on the surface of a silicon wafer by the same method as in Example 3 except that Comparative Compound 1 was used as the thin-film forming raw material, which was used in an atomic layer deposition method, in place of Ruthenium Compound No. 8, and the temperature of the raw material container was changed to 110°C. When the composition of the thin-film was analyzed by X-ray photoelectron spectroscopy, the thin-film was a thin-film containing ruthenium, and a residual carbon amount was 2.7 atom%. In addition, when the film thickness of the thin-film was measured by scanning electron microscopy, the thin-film formed on the surface of the silicon wafer was a film having a film thickness of from 6 nm to 7 nm, the film not being flat and smooth.

### [Comparative Example 2]

A thin-film was produced on the surface of a silicon wafer by the same method as in Example 3 except that Comparative Compound 2 was used as the thin-film forming raw material, which was used in an atomic layer deposition method, in place of Ruthenium Compound No. 8, and the temperature of the raw material container was changed to 125°C. When the composition of the thin-film was analyzed by X-ray photoelectron spectroscopy, the thin-film was a thin-film containing ruthenium, and a residual carbon amount was 3.2 atom%. In addition, when the film thickness of the thin-film was measured by scanning electron microscopy, the thin-film formed on the surface of the silicon wafer was a film having a film thickness of from 5 nm to 6 nm, the film not being flat and smooth.

Comparative Compound 1 and Comparative Compound 2 each had a low vapor pressure, and hence the temperature of the raw material container was required to be set higher in Comparative Examples 1 and 2 than in Examples 3 and 4 and Reference Example 5. As a result, it is conceived that each of Comparative Compound 1 and Comparative Compound 2 was thermally decomposed, and a ruthenium-containing thin-film that was not flat and smooth and had a large residual carbon amount was formed.

As described above, it was shown that a high-quality ruthenium-containing thin-film that was flat and smooth and had a small residual carbon amount was able to be obtained with high productivity when the ruthenium-containing thin-film was produced through use of the thin-film forming raw material, which was used in an atomic layer deposition method, of the present invention. In particular, it was shown that a high-quality ruthenium-containing thin-film that was flat and smooth and had a remarkably small residual carbon amount was able to be obtained with extremely high productivity when each of Ruthenium Compounds No. 7 and No. 8 was used as the thin-film forming raw material, which was used in an atomic layer deposition method. vaporization under the conditions of a raw material container temperature of 100°C and a raw material container internal pressure of 100 Pa is introduced into a film formation chamber (raw material introduction step), and the raw material gas is caused to deposit on the surface of the substrate at a system pressure of 100 Pa for 20 seconds, to thereby form a precursor thin-film (precursor thin-film formation step).
(2) The raw material gas that has not deposited on the surface of the substrate is evacuated from the system through argon purging for 15 seconds (evacuation step).
(3) A reactive gas is introduced into the film formation chamber, and the precursor thin-film is caused to react with the reactive gas at a system pressure of 100 Pa for 20 seconds (thin-film formation step).
(4) The reactive gas that is unreacted and a by-product gas are evacuated from the system through argon purging for 15 seconds (evacuation step).

### [Example 4]

A thin-film was produced on the surface of a silicon wafer by the same method as in Example 3 except that Ruthenium Compound No. 7 was used as the thin-film forming raw material, which was used in an atomic layer deposition method, in place of Ruthenium Compound No. 8. When the composition of the thin-film was analyzed by X-ray photoelectron spectroscopy, it was recognized that the thin-film was a thin-film of ruthenium metal, and a residual carbon amount was less than 0.1 atom%, which was a detection limit. In addition, when the film thickness of the thin-film was measured by scanning electron microscopy, the thin-film formed on the surface of the silicon wafer was a flat and smooth film having a film thickness of 10 nm, and a film thickness of about 0.10 nm was obtained per cycle.

### [Example 5]

A thin-film was produced on the surface of a silicon wafer by the same method as in Example 3 except that Ruthenium Compound No. 10 was used as the thin-film forming raw material, which was used in an atomic layer deposition method, in place of Ruthenium Compound No. 8, and the reactive gas was changed to hydrogen plasma (plasma output: 100 W), and the ALD apparatus was changed to the ALD apparatus of FIG. 3. When the composition of the thin-film was analyzed by X-ray photoelectron spectroscopy, it was recognized that the thin-film was a thin-film of ruthenium metal, and a residual carbon amount was less than 0.1 atom%, which was a detection limit. In addition, when the film thickness of the thin-film was measured by scanning electron microscopy, the thin-film formed on the surface of the silicon wafer was a flat and smooth film having a film thickness of 9 nm, and a film thickness of about 0.09 nm was obtained per cycle.

### [Comparative Example 1]

A thin-film was produced on the surface of a silicon wafer by the same method as in Example 3 except that Comparative Compound 1 was used as the thin-film forming raw material, which was used in an atomic layer deposition method, in place of Ruthenium Compound No. 8, and the temperature of the raw material container was changed to 110°C. When the composition of the thin-film was analyzed by X-ray photoelectron spectroscopy, the thin-film was a thin-film containing ruthenium, and a residual carbon amount was 2.7 atom%. In addition, when the film thickness of the thin-film was measured by scanning electron microscopy, the thin-film formed on the surface of the silicon wafer was a film having a film thickness of from 6 nm to 7 nm, the film not being flat and smooth.

### [Comparative Example 2]

A thin-film was produced on the surface of a silicon wafer by the same method as in Example 3 except that Comparative Compound 2 was used as the thin-film forming raw material, which was used in an atomic layer deposition method, in place of Ruthenium Compound No. 8, and the temperature of the raw material container was changed to 125°C. When the composition of the thin-film was analyzed by X-ray photoelectron spectroscopy, the thin-film was a thin-film containing ruthenium, and a residual carbon amount was 3.2 atom%. In addition, when the film thickness of the thin-film was measured by scanning electron microscopy, the thin-film formed on the surface of the silicon wafer was a film having a film thickness of from 5 nm to 6 nm, the film not being flat and smooth.

Comparative Compound 1 and Comparative Compound 2 each had a low vapor pressure, and hence the temperature of the raw material container was required to be set higher in Comparative Examples 1 and 2 than in Examples 3 to 5. As a result, it is conceived that each of Comparative Compound 1 and Comparative Compound 2 was thermally decomposed, and a ruthenium-containing thin-film that was not flat and smooth and had a large residual carbon amount was formed.

As described above, it was shown that a high-quality ruthenium-containing thin-film that was flat and smooth and had a small residual carbon amount was able to be obtained with high productivity when the ruthenium-containing thin-film was produced through use of the thin-film forming raw material, which was used in an atomic layer deposition method, of the present invention. In particular, it was shown that a high-quality ruthenium-containing thin-film that was flat and smooth and had a remarkably small residual carbon amount was able to be obtained with extremely high productivity when each of Ruthenium Compounds No. 7 and No. 8 was used as the thin-film forming raw material, which was used in an atomic layer deposition method.

## Claims

1. A ruthenium compound represented by the following general formula (2): 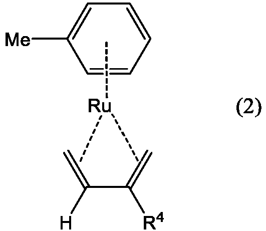 wherein R⁴ represents a hydrogen atom or an alkyl group having 1 to 5 carbon atoms.

2. A thin-film forming raw material, comprising the ruthenium compound of claim 1.

3. A method of producing a thin-film, comprising forming a thin-film containing a ruthenium atom on a surface of a substrate through use of the thin-film forming raw material of claim 2.

4. The method of producing a thin-film according to claim 3, comprising:
a raw material introduction step of introducing a raw material gas obtained by vaporizing the thin-film forming raw material into a film formation chamber having a substrate set therein; and
a thin-film formation step of subjecting the ruthenium compound represented by the general formula (2) in the raw material gas to decomposition and/or a chemical reaction, to thereby form the thin-film containing a ruthenium atom on the surface of the substrate.

5. The method of producing a thin-film according to claim 4, further comprising, between the raw material introduction step and the thin-film formation step, a precursor thin-film formation step of forming a precursor thin-film on the surface of the substrate through use of the thin-film forming raw material,
wherein the thin-film formation step is a step of causing the precursor thin-film to react with a reactive gas, to thereby form the thin-film containing a ruthenium atom on the surface of the substrate.

## Patentansprüche

1. Rutheniumverbindung, dargestellt durch die folgende allgemeine Formel (2): 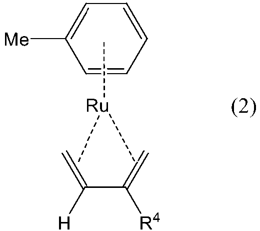 wobei R⁴ ein Wasserstoffatom oder eine Alkylgruppe mit 1 bis 5 Kohlenstoffatomen darstellt.

2. Dünnfilm-bildendes Ausgangsmaterial, umfassend die Rutheniumverbindung nach Anspruch 1.

3. Verfahren zur Herstellung eines Dünnfilms, umfassend das Bilden eines Dünnfilms, der ein Rutheniumatom enthält, auf der Oberfläche eines Substrats unter Verwendung des Dünnfilm-bildenden Ausgangsmaterials nach Anspruch 2.

4. Verfahren zur Herstellung eines Dünnfilms nach Anspruch 3, umfassend:
einen Ausgangsmaterialzuführungsschritt, bei dem ein durch Verdampfen des Dünnschicht-bildenden Ausgangsmaterials gewonnenes Ausgangsmaterialgas in eine Filmbildungskammer mit einem darin befindlichen Substrat eingeleitet wird; und einen Dünnfilmbildungsschritt, bei dem die Rutheniumverbindung, dargestellt durch die allgemeine Formel (2), in dem Ausgangsmaterialgas einer Zersetzung und/oder einer chemischen Reaktion unterzogen wird, um so den Dünnfilm, der ein Rutheniumatom enthält, auf der Oberfläche des Substrats zu bilden.

5. Verfahren zur Herstellung eines Dünnfilms nach Anspruch 4, weiter umfassend zwischen dem Ausgangsmaterialzuführungsschritt und dem Dünnfilmbildungsschritt einen Vorläufer-Dünnfilmbildungsschritt, bei dem ein Vorläufer-Dünnfilm auf der Oberfläche des Substrats unter Verwendung des Dünnfilm-bildenden Ausgangsmaterials gebildet wird,
wobei der Schritt der Dünnschichtbildung ein Schritt des Bewirkens ist, dass der Vorläufer-Dünnfilm mit einem Reaktionsgas reagiert, um so den Dünnfilm, der ein Rutheniumatom enthält, auf der Oberfläche des Substrats zu bilden.

## Revendications

1. Composé de ruthénium représenté par la formule générale suivante (2) : 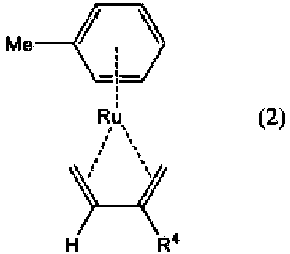 dans laquelle R⁴ représente un atome d'hydrogène ou un groupe alkyle ayant 1 à 5 atomes de carbone.

2. Matière première de formation de film mince, comprenant le composé de ruthénium selon la revendication 1.

3. Procédé de production d'un film mince, comprenant former un film mince contenant un atome de ruthénium sur une surface d'un substrat par l'utilisation de la matière première de formation de film mince selon la revendication 2.

4. Procédé de production d'un film mince selon la revendication 3, comprenant :
une étape d'introduction de matière première consistant à introduire une matière première gazeuse obtenue en vaporisant la matière première de formation de film mince dans une chambre de formation de film ayant un substrat posé en son sein ; et
une étape de formation de film mince consistant à soumettre le composé de ruthénium représenté par la formule générale (2) dans la matière première gazeuse à une décomposition et/ou une réaction chimique pour former de ce fait le film mince contenant un atome de ruthénium sur la surface du substrat.

5. Procédé de production d'un film mince selon la revendication 4, comprenant en outre, entre l'étape d'introduction de matière première et l'étape de formation de film mince, une étape de formation de film mince précurseur consistant à former un film mince précurseur sur la surface du substrat par l'utilisation de la matière première de formation de film mince,
dans lequel l'étape de formation de film mince est une étape consistant à amener le film mince précurseur à réagir avec un gaz réactif pour former de ce fait le film mince contenant un atome de ruthénium sur la surface du substrat.
